# EUROPÄISCHE PATENTANMELDUNG

(11) **EP 2 521 166 A1**
(43) Veröffentlichungstag der Anmeldung: **07.11.2012**
(21) Anmeldenummer: 12002367.6
(22) Anmeldetag: 30.03.2012
(51) Int. Cl.: H01L 21/56, C23C 4/12, H01L 21/683

(54) **Verfahren zum Herstellen eines Halbleiterbauelements**

(30) Priorität: 03.05.2011 DE 102011100255
(71) Anmelder: Danfoss Silicon Power GmbH, 24837 Schleswig (DE)
(72) Erfinder: Kock, Mathias, 25557 Gokels (DE); Eisele, Ronald, 24229 Surendorf (DE)
(74) Vertreter: Lobemeier, Martin Landolf

(57) **Zusammenfassung**

Erstellen eines Wafers (2), Aufbringen von Strukturen von Bauelementen (1) auf den Wafer (2), um einen Waferverbund auszubilden, Aufbringen einer Metallschicht (5) auf den Wafer (2), Entfernen der Metallschicht (5) in Nichtkontaktbereichen der Bauelemente (1), Aufbringen von Passivierungsrändem auf die Randbereiche der Bauelemente (1), Aufbringen des Wafers (2) auf eine von einem Spannring gehaltenen Folie (4), Vereinzeln der von der Folie (4) getragenen Bauelemente (1) voneinander aus dem Waferverbund heraus, Auflegen einer abdeckenden Maske (3) auf nicht zu beschichtende Bereiche der von der Folie (4) getragenen vereinzelten Bauelemente (1), Aufbringen einer Metallschicht (5) auf die mit der Maske (3) maskierten vereinzelten Bauelemente (1), Entfernen der Maske (3) und Abnehmen der Bauelemente (1) von der Folie (4) und Weiterbehandeln der vereinzelten Bauelemente (2), bei dem das Aufbringen einer Metallschicht (5) auf die mit der Maske (3) maskierten vereinzelten Bauelemente (1) mittels thermischem Spritzen erfolgt.

## Beschreibung

Die Erfindung betrifft ein Verfahren zum Herstellen eines Halbleiterbauelements mit den Schritten des Oberbegriffs des Anspruchs 1.

Ein derartiges Verfahren wird in der US- 6603191 B2 Patent beschrieben, bei dem das Aufbringen der Metallschicht durch galvanisches Abscheiden erfolgt. Bei dem Aufbringen der Kontaktschicht auf den die Bauelemente tragenden Wafer ist aber dessen Verwölbung durch das galvanisches Abscheiden einer Metallschicht kaum zu vermeiden.

Der Erfindung liegt damit die Aufgabe zugrunde, eine Verwölbung bei dem Aufbringen der Kontaktschicht zu vermeiden.

Erfindungsgemäß wird diese Aufgabe durch die Merkmale des Anspruchs 1 gelöst, der einzige Unteranspruch gibt eine bevorzugte Ausbildung der Erfindung an.

Weitere Merkmale und Vorteile der Erfindung ergeben sich aus der nachfolgenden Beschreibung, in der die Erfindung anhand einer Zeichnung erläutert wird.

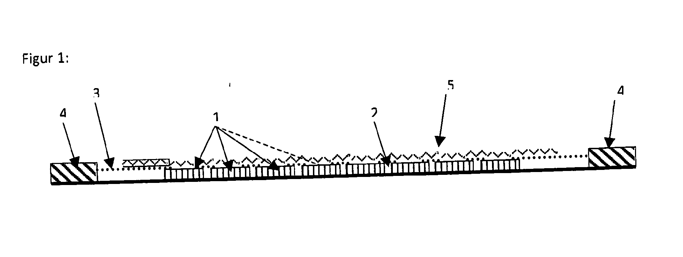

Dabei zeigt die einzige Figur den auf eine Folie aufgebrachten Wafer, bei dem die Bauelemente bereits gesägt und auf die Kontaktbereiche durch thermisches Spritzen, insbesondere durch Nanopulverabscheidung, eine Metallschicht aufgebracht ist.

Erfindungsgemäß wird also vorgeschlagen, in bekannter Weise bei dem Erstellen eines Wafers die Strukturen der Bauelemente und Passivierungsränder auf deren Randbereiche aufzubringen. Anschließend wird der Wafer auf eine von einem Spannring gehaltene Folie aufgelegt, die von der Folie getragenen Bauelemente werden voneinander z. B. durch Sägen unter Erhalt der Integrität der Folie aus dem Waferverbund vereinzelt.

Sodann wird eine die nicht zu beschichtenden Bereiche der Bauelemente abdeckende Maske auf die von der Folie getragenen vereinzelten Bauelemente aufgelegt, eine Metallschicht wird auf die Maske mittels Spritzen bzw. vorzugsweise durch Nanopulverplasmaabscheidung aufgebracht, die Maske wird entfernt und die Bauelemente werden von der Folie abgenommen und weiterbehandelt.

Die einzige Figur zeigt einen Wafer 2, der durch eine Mehrzahl von z. B. durch Sägen vereinzelten Bauelemente 1 gebildet wird. Eine Maske 3 deckt die nicht zu beschichtenden Bereiche der von einer Folie 4 getragenen vereinzelten Bauelemente 2 ab. Die Figur zeigt weiter die auf die Maske 3 und die Kontaktbereiche der Bauelemente mittels thermischem Spritzen bzw. vorzugsweise durch Nanopulverplasmaabscheidung aufgebrachte Metallschicht 5.

Bei dem vorgeschlagenen Verfahren, bei dem die Metallschicht durch thermischen Spritzen aufgebracht wird, wird eine Verwölbung des Wafers vermieden.

## Patentansprüche

1. Verfahren zum Herstellen eines Halbleiterbauelements mit folgenden Schritten:
- Erstellen eines Wafers (2),
- Aufbringen von Strukturen von Bauelementen (1) auf den Wafer (2), um einen Waferverbund auszubilden,
- Aufbringen einer Metallschicht (5) auf den Wafer (2),
- Entfernen der Metallschicht (5) in Nichtkontaktbereichen der Bauelemente (1),
- Aufbringen von Passivierungsrändern auf die Randbereiche der Bauelemente (1),
- Aufbringen des Wafers (2) auf eine von einem Spannring gehaltenen Folie (4),
- Vereinzeln der von der Folie (4) getragenen Bauelemente (1) voneinander aus dem Waferverbund heraus,
- Auflegen einer abdeckenden Maske (3) auf nicht zu beschichtende Bereiche der von der Folie (4) getragenen vereinzelten Bauelemente (1),
- Aufbringen einer Metallschicht (5) auf die mit der Maske (3) maskierten vereinzelten Bauelemente (1),
- Entfernen der Maske (3) und
- Abnehmen der Bauelemente (1) von der Folie (4) und Weiterbehandeln der vereinzelten Bauelemente (2).
**dadurch gekennzeichnet, dass** das Aufbringen einer Metallschicht (5) auf die mit der Maske (3) maskierten vereinzelten Bauelemente (1) mittels thermischem Spritzen erfolgt.

2. Verfahren zum Herstellen eines Halbleiterbauelements nach Anspruch 1, wobei das thermische Spritzen durch Nanopulverplasmaabscheidung erfolgt.
